# EUROPEAN PATENT SPECIFICATION

(11) **EP 3 684 962 B1**
(45) Date of publication and mention of the grant of the patent: **06.10.2021**
(21) Application number: 18765713.5
(22) Date of filing: 20.08.2018
(51) Int. Cl.: C23C 16/04, B65D 23/02, C23C 16/448, C23C 16/503, H01J 37/32, C23C 16/27, C23C 16/32, C23C 14/35, H01J 37/34

(54) **METHOD AND DEVICE FOR CARRYING OUT A DEPOSITION PROCESS AT THE OUTER SIDE AND/OR AT THE INNER SIDE OF A BODY**
VERFAHREN UND VORRICHTUNG ZUR DURCHFÜHRUNG EINES ABSCHEIDUNGSPROZESSES AN DER AUSSENSEITE UND / ODER AN DER INNENSEITE EINES KÖRPERS
PROCÉDÉ ET DISPOSITIF POUR RÉALISER UN PROCESSUS DE DÉPÔT SUR LE CÔTÉ EXTERNE ET/OU LE CÔTÉ INTERNE D'UN CORPS

(30) Priority: 20.09.2017 US 201762560886 P
(43) Date of publication of application: 29.07.2020
(73) Proprietor: C4E Technology GmbH, 96450 Coburg (DE)
(72) Inventor: BRORS, Daniel, Discovery Bay, CA 94505 (US)
(74) Representative: Gosdin, Carstensen & Partner Patentanwälte Partnerschaftgesellschaft mbB
(86) International application number: PCT/IB2018/000928
(87) International publication number: WO 2019/058163

(56) References cited:
- EP-A1- 2 660 353
- EP-A1- 2 799 593
- EP-A1- 3 031 946
- US-A1- 2006 196 419
- US-A1- 2009 176 035
- US-A1- 2009 311 443
- US-A1- 2013 213 805
- US-A1- 2014 287 161
- US-A1- 2015 027 875
- US-A1- 2015 136 585
- US-B1- 8 083 907
- US-B2- 6 852 202

## Description

The invention relates to a method for carrying out a deposition process at the outer side and/or at the inner side of a body having a longitudinal extension, in which at least one deposition is applied onto the outer and/or inner side of the body by means of a Chemical Vapor Deposition process (CVD) or a Plasma-Enhanced Chemical Vapor Deposition process (PECVD) or a Physical Vapor Deposition process (PVD Sputtering), wherein the body is connected with one of the terminals of a power supply and wherein at least one filament is connected with the other one of the terminals of the power supply, wherein the at least one filament is arranged near the outer or inner side of the body to carry out the deposition at the body. An alternative method relates to a method for carrying out a deposition process by means of a magnetron sputtering process, wherein at least one radial magnetron, which is arranged within the body, and/or at least one circular magnetron, which is arranged around the body, is connected with a terminal of the power supply. Thereby the at least one filament, the at least one radial magnetron and/or the at least one circular magnetron is moved along at least a part of the longitudinal extension of the body relatively to the body. Furthermore, the invention relates to a device for carrying out such a deposition process. Various vacuum deposition processes such as PVD, CVD, PECVD and MB are well known in the art as well as respective apparatuses in which the deposition process can be carried out.

Insofar, reference is made for example to EP 2 799 593 A1**,** to US 2006/ 196419 A1**,** to EP 2 660 353 A1 and to US 2015/027875 A1**.**

This process is specifically useful for the coating of long objects which are used in the petroleum industry. Special requirements are given in that case of coating the interior or exterior of long objects, such as pipes, for example with an aspect ratio greater than 10:1, with materials providing corrosion resistance and low friction and reducing wear.

Corrosion resistance coatings on the interior of pipes have been a goal for many years, particularly in the field of the petroleum industry. A pre-known method of coating the interior of pipes to prevent or minimize corrosion involves coating the interior surface or exterior surface of pipes with organic materials such as epoxy or paint. The coating prevents corrosion of the pipe as long as the coating remains intact, however unrefined petroleum generally contains substantial amounts of abrasive materials such as sand which quickly erodes the organic coatings. What is needed is an inert (corrosion resistant) material that is hard enough to withstand the abrasion of sand particles in the petroleum. SiC (silicon carbide) is a prime candidate for coating the interior or exterior of long pipes to prevent corrosion and DLC (Diamond Like Coating) is a candidate for both corrosion resistance and reduction of friction.

When it comes to coating bodies by means of a method of the above mentioned kind which are quite long in relation to the diameter, i. e. when the aspect ratio between the length and the diameter is more than 10 like for example in the case of a tube, then specific problems arise. US 8,715,789 B2 proposes in this case to place a plurality of axially spaced filaments (i. e. anodes) along the length of the interior of the tube. Detrimentally, it was found that in this case the coating does not have a sufficient homogeneity, i.e. thickness along the length of the tube.

It is an object of the present invention to propose a method and a corresponding apparatus by which the above mentioned problems can be eliminated or at least decreased. Thus, it should become possible to coat a body (at its inner side and/or at its outer side) by means of the above mentioned process, wherein the coating has a high degree of homogeneity and thickness along the longitudinal direction of the body.

The solution of this object according to the invention is characterized in that the at least one filament (anode) is moved along at least a part of the longitudinal extension of the body relatively to the body with a predetermined velocity, namely that the at least one filament is moved with a velocity relatively to the longitudinal extension of the body between 4.0 mm/s and 45.0 mm/s, preferably between 8.0 mm/s and 13.0 mm/s. The same measure is taken in the case that the deposition process is carried out by means of a magnetron sputtering process.

Thereby, a pressure between 6.5 Pa and 70.0 Pa, preferably between 25.0 Pa and 40.0 Pa, can be maintained between the at least one filament and the body. Also, a pressure between 0.25 Pa and 1.5 Pa can be maintained between the at least one radial magnetron and/or the at least one circular magnetron and the body.

A process gas, preferably CH₄ and/or SiH₄, can be guided through a supply element to the at least one filament, wherein the supply element is guided together with the at least one filament along the longitudinal extension of the body. In this case it can be provided that two different process gases, preferably CH₄ and SiH₄, are guided through a supply element to a first and a second filament, wherein the supply elements are guided together with the first and second filaments along the longitudinal extension of the body.

To separate and optimize the two adjacent occurring deposition processes a separation element can be arranged between the first and second filaments, which prevents an exchange of gas between the areas of the first and second filaments. In this case a preferred embodiment provides that a radial distance is kept between the separation element and the body between 0.5 mm and 0.8 mm.

Another embodiment provides that a process gas, preferably Argon (Ar) gas, is guided through a supply element to the at least one radial magnetron and/or to the at least one circular magnetron, wherein the supply element is guided together with the at least one radial magnetron and/or the at least one circular magnetron along the longitudinal extension of the body.

At least one first filament and at least one second filament can be moved along at least a part of the longitudinal extension of the body, wherein the first and the second filaments are arranged with an axial distance in the direction of the longitudinal extension of the body.

A special embodiment of the invention proposes that at least one filament and at least one radial or circular magnetron are moved along at least a part of the longitudinal extension of the body, wherein the at least one filament and the at least one radial or circular magnetron are arranged with an axial distance in the direction of the longitudinal extension of the body. In this case it can be provided that two different process gases, preferably CH₄ and Ar, are guided through respective supply elements to the at least one filament and the at least one radial or circular magnetron, wherein the supply elements are guided together with the at least one filament and the at least one radial or circular magnetron along the longitudinal extension of the body.

The body can have a tubular shape.

The body has preferably an outer diameter and a length, wherein the ratio of the length to the diameter is at least 10.

A device for carrying out a deposition process at the outer side and/or at the inner side of a body having a longitudinal extension by means of a Chemical Vapor Deposition process (CVD) or a Plasma-Enhanced Chemical Vapor Deposition process (PECVD) or a Physical Vapor Deposition process (PVD sputtering), wherein the device comprises a vacuum chamber for receiving the body and a power supply with two terminals, wherein one terminal is connectable with the body and one terminal is connected with at least one filament, can be characterized - but not according to the invention - that moving means are arranged for moving the at least one filament relatively to the body or the body relatively to the at least one filament along at least a part of the longitudinal extension of the body with a predetermined velocity.

Also in the case of a deposition by means of a magnetron sputtering process according to the invention this measure is taken, i. e. moving means are arranged for moving the at least one radial magnetron and/or circular magnetron relatively to the body or the body relatively to the at least one radial magnetron and/or a circular magnetron along at least a part of the longitudinal extension of the body with a predetermined velocity.

Preferably, at least one supply element is arranged for supplying a process gas to the at least one filament or the at least one radial magnetron and/or circular magnetron.

At least one first filament and at least one second filament can be arranged with an axial distance in the direction of the longitudinal extension of the body.

The first and second filaments can be separated in the direction of the longitudinal extension by means of a separation element. In this case the separation element can be designed to keep a radial distance between the separation element and the body, wherein the radial distance is preferably between 0.5 mm and 0.8 mm. Also it can be provided that at least one first supply element and at least one second supply element are arranged for supplying process gases to the first and to the second filaments.

An efficient deposition is facilitated when the at least one filament is arranged in a toroidal shaped chamber which is designed to encircle that outer surface of the body. The same can apply in the case of a radial magnetron and/or a circular magnetron.

The at least one first filament can be arranged in a first toroidal shaped chamber and the at least one second filament can be arranged in a second toroidal shaped chamber, wherein the two toroidal shaped chambers are arranged in an axial distance in the direction of the longitudinal extension of the body. In this case it can be provided that at least one first supply element is leading in the first toroidal shaped chamber and that at least one second supply element is leading in the second toroidal shaped chamber.

Preferably, process gases, specifically CH₄ can be used to deposit DLC and SiR₄ can be used to deposit Si as an adhesion layer or a metal adhesion layer such as Cr, Ti or Ta is sputtered on to the pipe surfaces. DLC will not adhere to iron surfaces which requires an adhesion layer of Si, Cr, Ti or TA to be deposited on the iron surfaces prior to the DLC deposition.

The evacuation of the chamber can for example be carried out by a rotary vane pump or by a scroll pump.

Thus, the main aspects of the present invention are as follows:
A method and a corresponding device are used especially for CVD and PECVD coating of long pipes (tubes).

The invention relates to moving a filament or filaments or a radial/circular magnetron the length of a long pipe causing a localized CVD deposition (or other deposition processes such as metals deposited by a radial magnetron) in close proximity of the filament or filaments successfully coating the entire interior or exterior of a long pipe with a hard and corrosion resistant coating. The preferred coatings include SiC and DLC but are not limited to those coatings.

DLC is presently used to coat the interior of hollow objects, such as short pipes, known as crossovers in the petroleum industry, to prevent corrosion. DLC is hard (typically 15 to 20 GPa) and totally resistant to corrosion. DLC coating of crossovers has proven to a good solution to prevent corrosion of crossovers. Attempts have been made to coat long pipes, i.e. pipes with an aspect ratio greater than 10:1, with DLC with no success. DLC must be deposited with a CVD or PECVD process.

The proposed assembly contains an anode or anodes (filaments) or magnetrons that moves from one end of an object to be coated to the other end of the object, such as coating the interior of a pipe but not limited to a pipe, or coating the exterior of an object by movement of the assembly from one end of the object to the other end to cause a uniform deposition over the entire interior or exterior of the object.

For creating the required coating a suitable precursor gas or gases are fed to the area or region of the filaments. The precursor gas or gases are thus directed into specific areas of a pipe.

The proposed concept allows the deposition of materials while a relative movement takes place between the anodes (filaments) or magnetrons and the body to be coated. Relevant is only a relative movement, i. e. it does not matter if the filament is moving and the tube rests or vice versa.

The material can be deposited on the interior or exterior or both the interior and exterior of an object at the same time.

Also, a sequential deposition of (two different or of the same) materials is taken in consideration. Here, specifically more than one deposition areas can be placed one above the other. Furthermore, two or more anodes or an anode and a radial magnetron can be placed in separate cavities (toroid chambers). Hereby, separate precursor gases can be injected into separate cavities to allow for different materials to be simultaneously deposited or precursor gases are injected into a cavity and a radial magnetron is used to deposit a metal in a separate cavity.

Additional measures which can be taken are to allow plasma heating of the pipe prior to the (CVD) deposition process.

Also, it is possible to move the filaments or magnetrons to one or more defined areas of the pipe allowing (CVD or PVD) deposition on selected areas.

A further beneficial embodiment of the invention is to allow to rework or recoat areas to repair a damaged coating, such as a coating was damaged by processes such as weld and or sandblasting.

Finally, it is possible to connect a number of coated bodies (tube) at their axial ends by means of a welding process. By doing so the applied coating will be destroyed in many cases. Thus, it is possible to repeat the coating at that location by the above described technology or by pre-known techniques.

In the drawings embodiments according to the state of the art and according to the invention are shown.
- Fig. 1: shows schematically an apparatus for applying a deposition onto an inner side of a short tube by a CVD or PECVD vacuum deposition process according to the state of the art,
- Fig. 2: shows schematically an apparatus for applying a deposition onto the inner side of a tube by a CVD or PECVD vacuum deposition process according to a first embodiment of the invention,
- Fig. 3: shows schematically an apparatus for applying a deposition onto the inner side of a tube by a CVD or PECVD vacuum deposition process according to a second embodiment of the invention,
- Fig. 4: shows schematically an apparatus for applying a deposition onto the outer side of a tube by a CVD or PECVD vacuum deposition process according to a third embodiment of the invention,
- Fig. 5: shows schematically an apparatus for applying a deposition onto the outer side of a tube by a CVD or PECVD vacuum deposition process according to a fourth embodiment of the invention,
- Fig. 6: shows schematically an apparatus for applying a deposition onto the outer side of a tube by a CVD or PECVD deposition process and a PVD deposition by a radial magnetron and
- Fig. 7: shows schematically an apparatus for applying a deposition onto the inner side of a tube by a CVD or PECVD deposition process and a PVD deposition by a radial magnetron.

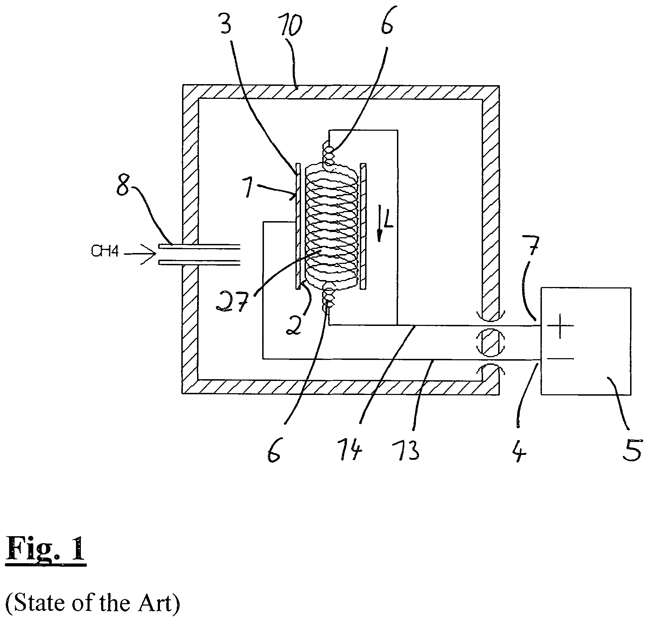

In Fig. 1 a typical CVD or PECVD deposition system is shown according to the state of the art.

As can be seen from Fig. 1 a body 3 (work piece: crossover) with an outer side 1 and an inner side 2 which has to be coated is attached to a high voltage power supply 5 where by the negative lead (cathode) 13 is attached to the body 3 (work piece) and the positive lead (anode) 14 is attached to filaments 6. The power supply 5 has a first terminal 4 and a second terminal 7. The body 3 is in a vacuum chamber 10, a carbon precursor, such as CH₄ is injected through a supply element 8 (pipe) into the vacuum clamber 10 or a Silicon plus a Carbon precursor such as SiH₄ + CH₄ is used to deposit SiC.

After evacuating the vacuum chamber 10 a high voltage, typically 400 to 600 V, is applied between the body 3 and the filaments 6 causing a plasma discharge 27 to occur within the interior of the body 3 resulting in dissociation of the CH₄ releasing C atoms which condense on the inner side 2 of the body 3 forming a DLC (Diamond Like Coating) deposit on the inner side 2 of the body 3.

This process works well for short pipes, i. e. < 10:1 aspect ratio, but does not work for long pipes, > 10:1 aspect ratio.

As the aspect ratio of the pipe (body 3) increases, the DLC deposition occurs only in close proximity to the filaments 6 at each end of the pipe, with little or no DLC coating within the pipe at a distance > 10:1 aspect ratio. Attempts have been made to coat the interior of long pipes by passing a wire filament from one end of the pipe to the other end to ignite a plasma the entire length of the pipe, like described in above mentioned US 8,715,789 B2, however the plasma does not ignite uniformly but ignites at one or two (or several) points within the pipe causing a DLC coating at those spots and nowhere else within the pipe.

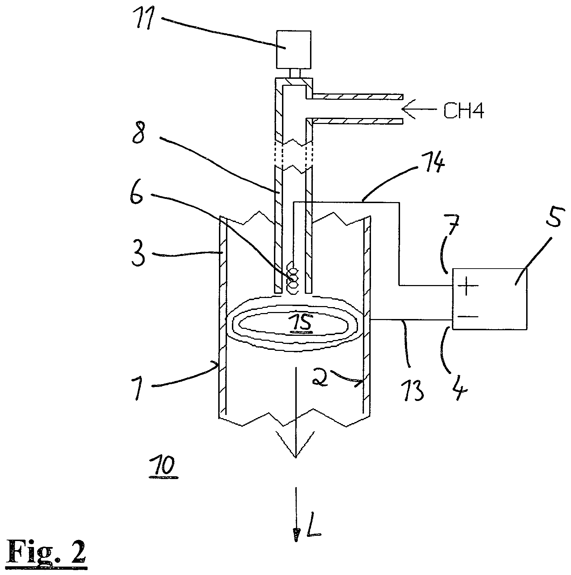

To overcome this problem the present invention proposes a solution which is shown for four different embodiments, being examples and do not limit the invention, as shown in figures 2 to 5.

The proposed solution to coating long pipes 3 is to pass a moving anode 6 from one end of the pipe to the other end resulting in a uniform coating over the entire length of the long pipe (it should be noted that a relative movement between body and filament (anode) is relevant, i. e. it does not matter if the filament is moved at stationary body or the body is moved at stationary filament).

It should be further mentioned at first that the basis technology in the cases of figures 2 to 5 is the same as described above and especially in figure 1, i. e. a vacuum chamber is used (only schematically depicted in figures 2 to 5) which is evacuated by a suitable pump before the power of the power supply is switched on to create a plasma by which the (inner or outer) surface of the body 3 is coated.

Fig. 2 shows a long pipe 3 in a vacuum chamber 10. Filament (anode) 6 is attached to positive lead 14 which is attached to the positive terminal 7 of the high voltage power supply 5. The pipe 3 (cathode) is attached to the terminal 7 of the high voltage power supply 5 through negative lead 13. The electrical feed-through from the vacuum chamber 10 to the power supply 5 are not shown. A carbon precursor, such as CH₄ for the deposition of DLC or a precursor containing CH₄ + SiH₄ is used for the deposition of SiC, is injected into the interior of the pipe 3 through supply element (pipe) 8.

The pressure in the interior of the pipe 3 is adjusted to 50 to 500 mTorr, preferably to 100 to 300 mTorr (1 bar = 750,062 Torr) such that a plasma 15 will form which disassociates the precursor gas CH₄ resulting in the deposition of DLC or SiC on the inner side 2 of the body 3. A vacuum pump, not shown, is attached to the end of the body 3 (see arrow) to pump out the reacted gases. The supply element 8 (gas injection pipe) and the filament lead 14 (positive lead) are attached to a moving means, schematically shown at 11, which allows the pipe 3 and filament 6 to traverse the entire length of the long pipe 3 while maintaining a vacuum seal to the supply element (gas injection pipe) 8 and the positive lead 14. Such an arrangement allows the entire interior of the long pipe 3 to be uniformly coated with DLC or SiC.

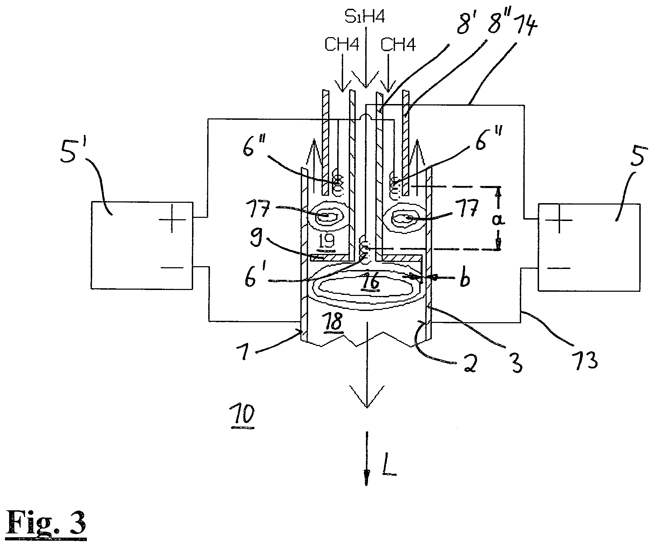

Fig. 3 shows an arrangement whereby two separate-sequential coatings are applied to the inner side 2 of the body (pipe) 3. Such arrangement is useful when DLC is deposited on a steel pipe 3. Si is typically deposited onto steel substrates as an adhesion layer for the DLC prior to the DLC deposition. Without the Si adhesion layer, the DLC will not adhere to the steel substrate. The deposition is confined to two distinct deposition areas comprised of a lower plasma area 16 and an upper plasma area 17 within pipe 3.

The lower plasma 16 is used to deposit Si on the inner pipe surface. The upper plasma area 17 is used to deposit DLC. The whole depicted assembly moves downward in the pipe 3 (by moving means 11, not shown in figure 3, but in figure 2) to deposit Si and then DLC on the Si on the entire interior surface of pipe 3. The pipe 3 (cathode) is attached to the negative terminal of the high voltage power supply 5 by negative lead 13. First filament 6' (anode) is attached to the positive terminal of the power supply through positive lead 14. SiH₄ gas is injected into space 18 through a first supply element (inner pipe) 8' to an appropriate pressure of 50 to 500 mTorr and preferably 200 to 300 mTorr which results in a plasma 16 to form when the high voltage supply 5 is energized to 400 to 600 Volts. The exhaust gases are pumped out of the pipe 3 by a vacuum pump (not shown), see downward directed arrow, attached to the lower end of pipe 3.

A similar arrangement is used to form a upper plasma 17 used to deposit DLC with the exhaust gases being pumped out of the top of the pipe by a vacuum pump, not shown, attached to the top of pipe 3. A precursor such as CH₄ is injected into a second supply element 8" (outer pipe) to an appropriate pressure such as 50 to 500 mTorr and preferably 200 to 300 mTorr such that a plasma 17 will form when a high voltage is applied between second filament (anode) 6" attached to power supply 5' through lead 14' and the pipe 3 (cathode) is attached to power supply 5' through lead 13'.

The exhaust gases SiH₄ are pumped out of the top of pipe 3 by a vacuum pump (not shown), see upward directed arrow, attached to the top of outer pipe 3. Exhaust gases CH₄ are pumped out of the bottom of pipe 3 by a vacuum pump (not shown), see downward directed arrow, attached to the bottom of outer pipe 3.

A separation element 9 being a plate is attached to the first supply element 8' (inner pipe) to act as a baffle between the upper plasma 17 and the lower plasma 16 to prevent the precursor gases SiH₄ and CH₄ from mixing. There is a narrow space of approximately 0.010 to 0.050 inches between the separation element 9 (baffle plate) and the inner pipe side wall 2 and preferably 0.020 to 0.030 inches (1 inch = 2.54 cm). The axial distance a between the first filament 6' and the second filament 6" is depicted as a. Also the radial distance b between the separation element 9 and the inner side 2 of the body 3 is shown.

A typical deposition procedure begins with the assembly located at the top of the pipe 3. The vacuum chamber 10 and the interior of the pipe 3 is evacuated to typically less than 20 mTorr. The precursor gases SiH₄ and CH₄ are turned on to appropriate flows such that the space 18 and 19 are at appropriate pressures of 200 to 300 mTorr at which time the power supplies are turned on and plasma 16 and 17 are formed. The assembly is then lowered in the direction of the longitudinal extension L of the body 3 at a rate of 10 to 100 inches per minute, and preferably at a rate of 20 to 30 inches per minute. When the assembly reaches the lower end of the pipe 3, the power supplies are turned off and then the gases are turned off. The assembly is raised to the upper end of the pipe 3, the vacuum pumps are turned off and the vacuum chamber 10 as well as spaces 18 and 19 are backfilled, typically with N₂, to atmospheric pressure. The vacuum connections (not depicted) at the top and bottom of pipe 3 are disconnected. The depicted assembly is lifted out of the pipe 3. The coated pipe is removed and a new, uncoated pipe is placed in the machine for coating.

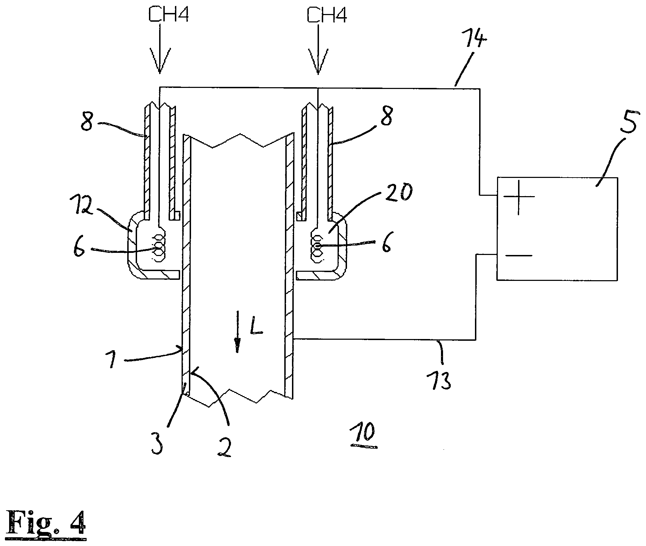

Fig. 4 shows the assembly for coating the outer side 1 (exterior) of a long pipe 3 using a moving filament (anode) 6. Again, the long pipe 3 is in the vacuum chamber 10. The long pipe 3 is surrounded by a toroidal shaped chamber 12. A filament (or filaments) 6 resides in the space 20 between the toroidal shaped chamber 12 and the pipe 3. The filament 6 is attached to the positive terminal of the high voltage power supply, not shown. The pipe 3 (cathode) is connected to the negative terminal of the high voltage power supply through negative lead 13. A precursor gas CH₄ is injected into space 20 through one or more supply elements 8 (pipes) for a DLC deposition on the exterior of pipe 3 or a precursor gas such as Sif₄ + CH₄ is injected into space 20 for a SiC deposition on pipe 3.

The whole depicted assembly, consisting of the toroidal shaped chamber 12 and the filament 6 and the supply element 8 (gas injection pipe) is placed at the top of pipe 3. The vacuum chamber 10 is connected to a vacuum pump, not shown. The vacuum chamber 10 is evacuated and the precursor gas is injected into the space 20. The precursor gas flow is set such that the gas pressure in space 20 reaches 50 to 500 mTorr and preferably 200 to 300 mTorr. The high voltage power supply is turned on between 400 to 600 Volts and the DLC or SiC deposition begins on the outer side 1 of pipe 3 in the area surrounded by toroidal shaped chamber 12. The whole assembly is then slowly lowered by moving means (not depicted here, see figure 2) down the entire length in longitudinal extension L on pipe 3 at a rate of 5 to 100 inches per minute and preferably at a rate of 8 to 12 inches per minute. The power supply and the precursor gases are turned off when the assembly reaches the bottom of pipe 3. The whole assembly is raised to the top of pipe 3. The vacuum pump attached to chamber 10 is turned off and the vacuum chamber 10 is backfilled to atmospheric pressure so pipe 3 can be removed from the vacuum chamber 10.

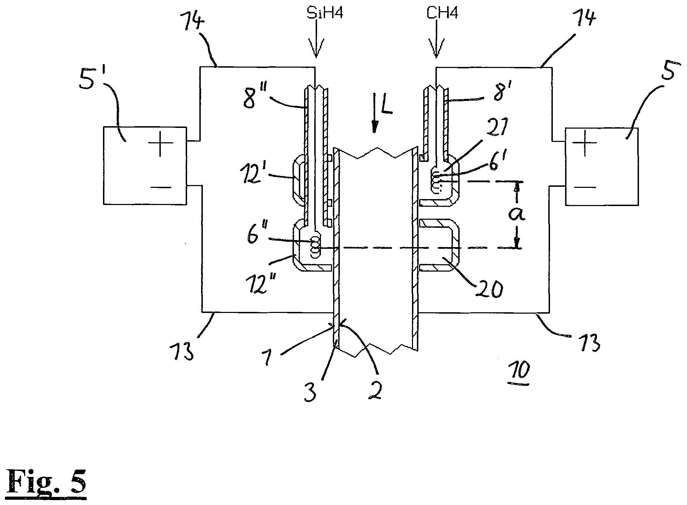

Fig. 5 depicts an assembly which contains two separate plasma deposition areas following in longitudinal extension L at an axial distance a. Typically, Si is deposited as an adhesion layer prior to a DLC deposition. The shown assembly allows for a Si deposition prior to a DLC deposition. The shown assembly consists of a first toroidal shaped chamber 12' and a second toroidal shaped chamber 12"; in each chamber 12', 12" at least one filament 6, namely a first filament 6' and a second filament 6", is arranged. Also respective first and second supply elements 8' and 8" are arranged. A Si precursor gas SiH₄ is injected into the space 20 and a DLC precursor gas CH₄ is injected into space 21 allowing for Si to be deposited onto pipe 3 prior to the DLC deposition as the shown assembly is lowered by moving means (not shown) from the top of pipe 3. Such an arrangement allows for a uniform deposition of DLC over a Si adhesion layer.

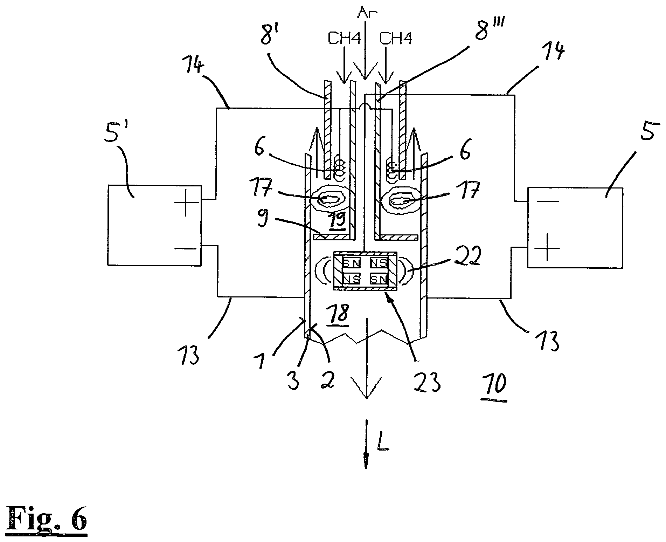

Fig. 6 shows an arrangement whereby two separate-sequential coatings are applied to the inner side 2 of the body (pipe) 3. Si is typically deposited onto steel substrates as an adhesion layer for the DLC prior to the DLC deposition, however Cr, Ti or Ta can also be used for an adhesion layer. Cr, Ti or Ta can provide better adhesion than Si if Cr, Ti or Ta are applied in-situ by PVD (sputtering) prior to the DLC. The deposition is confined to two distinct deposition areas comprised of a lower plasma area 22 and an upper plasma area 17 within pipe 3. The lower plasma 22 is used to deposit metal (Cr, Ti, Ta) on the inner pipe surface 2 of pipe 3. The upper plasma area 17 is used to deposit DLC. The whole depicted assembly moves downward in the pipe 3 (by moving means 11, not shown in figure 6, but in figure 2) to deposit metal and then DLC on the entire interior surface 2 of pipe 3. The pipe 3 (cathode) is attached to the negative terminal of the high voltage power supply 5' by lead 13'. Filament 6' (anode) is attached to the positive terminal of the power supply 5' through lead 14'. SiH₄ gas is injected into space 19 through (outer pipe) 8' to an appropriate pressure of 50 to 500 mTorr and preferably 200 to 300 mTorr which results in a plasma 17 to form when the high voltage supply 5' is energized to 400 to 600 Volts. The exhaust gases are pumped out of the pipe 3 by a vacuum pump (not shown), see upward directed arrows, attached to the upper end of pipe 3.

A similar arrangement is used to form a lower plasma 22 used to deposit metal from magnetron 23. The lead 14" attached to positive terminal of power supply 5" is attached to pipe 3 and the negative lead 13" attached to power supply 5" is attached to the magnetron. Argon gas is injected into space 18 via supply element 8"' to a pressure between 2 and 10 mTorr with the exhaust Ar pumped out of space 18 through a vacuum pump (not shown) attached to the lower end of pipe 3. A voltage between 400 and 600 Volts is applied to the magnetron by power supply 5"

A separation element 9 being a plate is attached to the first supply element 8' (inner pipe) to act as a baffle between the upper plasma 17 and the lower plasma 16 to prevent the precursor gases SiH₄ and Ar from mixing. There is a narrow space of approximately 0.010 to 0.050 inches between the separation element 9 (baffle plate) and the inner pipe side wall 2 and preferably 0.020 to 0.030 inches (1 inch = 2.54 cm).

A typical deposition procedure begins with the assembly located at the top of the pipe 3. The vacuum chamber 10 and the interior of the pipe 3 is evacuated to typically less than 20 mTorr. The precursor gases SiH₄ and Ar are turned on to appropriate flows such that the space 18 is at 2 to 10 mTorr and space 19 is 100 to 300 mTorr at which time power supplies 5' and 5" are turned on and plasma 17 and 22 are formed. The assembly is then lowered in the direction of the longitudinal extension L of the body 3 at a rate of 10 to 100 inches per minute, and preferably at a rate of 20 to 30 inches per minute. When the assembly reaches the lower end of the pipe 3, the power supplies are turned off and then the gases are turned off. The assembly is raised to the upper end of the pipe 3, the vacuum pumps are turned off and the vacuum chamber 10 as well as spaces 18 and 19 are backfilled, typically with N₂, to atmospheric pressure. The vacuum connections (not depicted) at the top and bottom of pipe 3 are disconnected. The depicted assembly is lifted out of the pipe 3. The coated pipe is removed and a new, uncoated pipe is placed in the machine for coating.

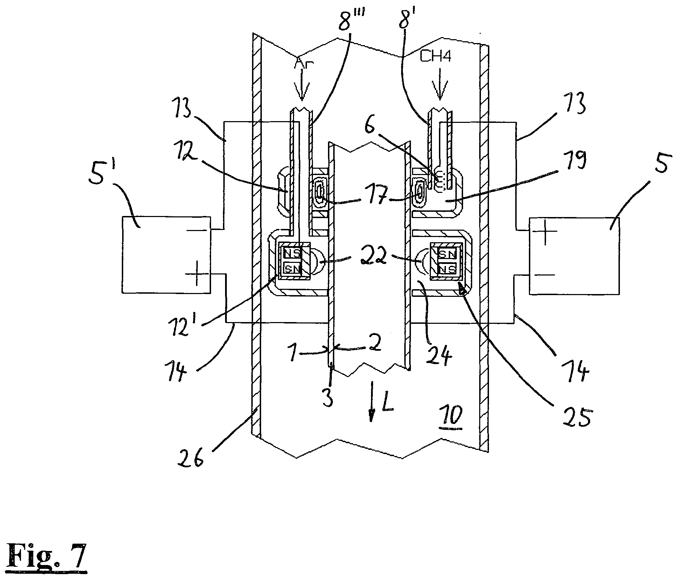

Fig. 7 depicts an assembly arranged to coat the exterior of a pipe with sputtered metal followed by a deposition of DLC. The deposition is confined to two distinct deposition areas comprised of a lower plasma area 22 and an upper plasma area 17 within pipe 3. The lower plasma 22 is used to deposit metal (Cr, Ti, Ta) on the outer pipe surface 1 of pipe 3. The upper plasma area 17 is used to deposit DLC. The whole depicted assembly moves downward in the pipe 3 (by moving means 11, not shown in figure 7, but in figure 2) to deposit metal and then DLC on the entire interior surface 1 of pipe 3. The pipe 3 (cathode) is attached to the negative terminal of the high voltage power supply 5" by lead 13". Filament 6" (anode) is attached to the positive terminal of the power supply 5" through lead 14". SiH₄ gas is injected into space 19 enclosed by toroidal shaped chamber 12 through pipe 8' to an appropriate pressure of 50 to 500 mTorr and preferably 200 to 300 mTorr which results in a plasma 17 to form when the high voltage supply 5" is energized to 400 to 600 Volts. The exhaust gases are pumped out of the chamber 9 by a vacuum pump (not shown), attached to the lower end of pipe 9. The pipe 3 (anode) is attached to the positive terminal of the high voltage power supply 5' by lead 14'. Circular magnetron 23 is attached to the negative terminal of the power supply 5' through lead 13'. Ar gas is injected into space 24 enclosed by toroidal shaped chamber 12' through pipe 8'" to an appropriate pressure of 2 to 10 mTorr which results in a plasma 22 to form when the high voltage supply 5' is energized to 400 to 600 Volts. The exhaust gases are pumped out of the chamber 9 by a vacuum pump (not shown), attached to the lower end of pipe 9.

A similar arrangement is used to form a lower plasma 22 used to deposit metal from magnetron 23. The lead 14" attached to positive terminal of power supply 5" is attached to pipe 3 and the negative lead 13" attached to power supply 5" is attached to the magnetron. Ar gas is injected into space 18 to a pressure between 2 and 10 mTorr with the exhaust Ar pumped out of space 18 through a vacuum pump (not shown) attached to the lower end of pipe 3. A voltage between 400 and 600 Volts is applied to the magnetron by power supply 5".

### Reference Numerals:

- 1: Outer side of the body
- 2: Inner side of the body
- 3: Body (tube / pipe)
- 4: Terminal of the power supply
- 5: Power supply
- 5': Power supply
- 5": Power supply
- 6: Filament
- 6': First filament
- 6": Second filament
- 7: Terminal of the power supply
- 8: Supply element
- 8': First supply element
- 8": Second supply element
- 8'": Supply element for Ar gas
- 9: Separation element
- 10: Vacuum chamber
- 11: Moving means
- 12: Toroidal shaped chamber
- 12': First toroidal shaped chamber
- 12": Second toroidal shaped chamber
- 13: Negative lead
- 14: Positive lead
- 15: Plasma
- 16: Lower plasma
- 17: Upper plasma
- 18: Space
- 19: Space
- 20: Space
- 21: Space
- 22: Magnetron plasma
- 23: Radial magnetron
- 24: Space
- 25: Circular magnetron
- 26: Circular chamber wall (pipe)
- 27: Hollow cathode plasma

- L: Longitudinal extension
- a: Axial distance
- b: Radial distance

## Claims

1. Method for carrying out a deposition process at the outer side (1) and/or at the inner side (2) of a body (3) having a longitudinal extension (L), in which at least one deposition is applied onto the outer and/or inner side (1, 2) of the body (3) by means of a Chemical Vapor Deposition process (CVD) or a Plasma-Enhanced Chemical Vapor Deposition process (PECVD) or a Physical Vapor Deposition process (PVD Sputtering), wherein the body (3) is connected with one of the terminals (4) of a power supply (5) and wherein at least one filament (6) is connected with the other one of the terminals (7) of the power supply (5), wherein the at least one filament (6) is arranged near the outer or inner side (1, 2) of the body (3) to carry out the deposition at the body (3), wherein the at least one filament (6) is moved along at least a part of the longitudinal extension (L) of the body (3) relatively to the body (3) with a predetermined velocity,
**characterized in that**
the at least one filament (6) is moved with a velocity relatively to the longitudinal extension (L) of the body (3) between 4.0 mm/s and 45.0 mm/s, preferably between 8.0 mm/s and 13.0 mm/s.

2. Method for carrying out a deposition process at the outer side (1) and/or at the inner side (2) of a body (3) having a longitudinal extension (L), in which at least one deposition is applied onto the outer and/or inner side (1, 2) of the body (3) by means of a magnetron sputtering process, wherein the body (3) is connected with one of the terminals (4) of a power supply (5) and wherein at least one radial magnetron (23), which is arranged within the body (3), and/or at least one circular magnetron (25), which is arranged around the body (3), is connected with the other one of the terminals (7) of the power supply (5), wherein the radial magnetron (23) and/or the circular magnetron (25) is arranged near the outer or inner side (1, 2) of the body (3) to carry out the deposition at the body (3), wherein the at least one radial magnetron (23) and/or the at least one circular magnetron (25) is moved along at least a part of the longitudinal extension (L) of the body (3) relatively to the body (3) with a predetermined velocity,
**characterized in that**
the at least one radial magnetron (23) and/or the at least one circular magnetron (25) is moved with a velocity relatively to the longitudinal extension (L) of the body (3) between 4.0 mm/s and 45.0 mm/s, preferably between 8.0 mm/s and 13.0 mm/s.

3. Method according to claim 1, **characterized in that** a pressure between 6.5 Pa and 70.0 Pa, preferably between 25.0 Pa and 40.0 Pa, is maintained between the at least one filament (6) and the body (3).

4. Method according to claim 2, **characterized in that** a pressure between 0.25 Pa and 1.5 Pa is maintained between the at least one radial magnetron (23) and/or the at least one circular magnetron (25) and the body (3).

5. Method according to claim 1 or 3, **characterized in that** a process gas, preferably CH₄ and/or SiH₄, is guided through a supply element (8) to the at least one filament (6), wherein the supply element (8) is guided together with the at least one filament (6) along the longitudinal extension (L) of the body (3).

6. Method according to claim 5, **characterized in that** two different process gases, preferably CH₄ and SiH₄, are guided through a supply element (8', 8") to a first and a second filament (6', 6"), wherein the supply elements (8', 8") are guided together with the first and second filaments (6', 6") along the longitudinal extension (L) of the body (3).

7. Method according to claim 6, **characterized in that** a separation element (9) is arranged between the first and second filaments (6', 6"), which prevents an exchange of gas between the areas of the first and second filaments (6', 6").

8. Method according to claim 7, **characterized in that** a radial distance (b) is kept between the separation element (9) and the body (3) between 0.5 mm and 0.8 mm.

9. Method according to claim 2 or 4, **characterized in that** a process gas, preferably Ar gas, is guided through a supply element (8"') to the at least one radial magnetron (23) and/or to the at least one circular magnetron (25), wherein the supply element (8"') is guided together with the at least one radial magnetron (23) and/or the at least one circular magnetron (25) along the longitudinal extension (L) of the body (3).

10. Method according to one of claims 1, 3, 5 to 8, **characterized in that** at least one first filament (6') and at least one second filament (6") are moved along at least a part of the longitudinal extension (L) of the body (3), wherein the first and the second filaments (6', 6") are arranged with an axial distance (a) in the direction of the longitudinal extension (L) of the body (3).

11. Method according to claim 1 and 2, **characterized in that** at least one filament (6) and at least one radial or circular magnetron (23, 25) are moved along at least a part of the longitudinal extension (L) of the body (3), wherein the at least one filament (6) and the at least one radial or circular magnetron (23, 25) are arranged with an axial distance (a) in the direction of the longitudinal extension (L) of the body (3).

12. Method according to claim 11, **characterized in that** two different process gases, preferably CH₄ and Ar, are guided through respective supply elements (8', 8", 8"') to the at least one filament (6) and the at least one radial or circular magnetron (23, 25), wherein the supply elements (8', 8", 8"') are guided together with the at least one filament (6) and the at least one radial or circular magnetron (23, 25) along the longitudinal extension (L) of the body (3).

13. Method according to one of claims 1 to 12, **characterized in that** the body (3) has a tubular shape, wherein the body (3) has preferably an outer diameter and a length, wherein the ratio of the length to the diameter is at least 10.

14. Device for carrying out a deposition process at the outer side (1) and/or at the inner side (2) of a body (3) having a longitudinal extension (L) by means of a magnetron sputtering process, wherein the device comprises a vacuum chamber (10) for receiving the body (3) and a power supply (5) with two terminals (4, 7), wherein one terminal (4) is connectable with the body (3) and one terminal (7) is connected with at least one radial magnetron (23) and/or a circular magnetron (25),
**characterized in that**
moving means (11) are arranged for moving the at least one radial magnetron (23) and/or circular magnetron (25) relatively to the body (3) or the body (3) relatively to the at least one radial magnetron (23) and/or a circular magnetron (25) along at least a part of the longitudinal extension (L) of the body (3) with a predetermined velocity.

15. Device according to claim 14, **characterized in that** at least one supply element (8) is arranged for supplying a process gas to the at least one radial magnetron (23) and/or circular magnetron (25).

## Patentansprüche

1. Verfahren zur Durchführung eines Abscheidungsprozesses an der Außenseite (1) und/oder an der Innenseite (2) eines eine Längserstreckung (L) aufweisenden Körpers (3), bei dem mittels eines chemischen Gasphasenabscheidungs-Verfahrens (CVD) oder eines plasmagestützten chemischen Gasphasenabscheidungs-Verfahrens (PECVD) oder eines physikalischen Gasphasenabscheidungs-Verfahrens (PVD-Sputtering) mindestens eine Abscheidung auf die Außen-und/oder Innenseite (1, 2) des Körpers (3) aufgebracht wird, wobei der Körper (3) mit einem der Anschlüsse (4) einer Stromversorgung (5) verbunden ist und wobei mindestens ein Filament (6) mit dem anderen der Anschlüsse (7) der Stromversorgung (5) verbunden ist, wobei das mindestens eine Filament (6) nahe der äußeren oder inneren Seite (1, 2) des Körpers (3) angeordnet ist, um die Abscheidung an dem Körper (3) durchzuführen, wobei das mindestens eine Filament (6) entlang mindestens eines Teils der Längserstreckung (L) des Körpers (3) relativ zu dem Körper (3) mit einer vorbestimmten Geschwindigkeit bewegt wird,
**dadurch gekennzeichnet,**
**dass** das mindestens eine Filament (6) mit einer Geschwindigkeit relativ zur Längserstreckung (L) des Körpers (3) zwischen 4,0 mm/s und 45,0 mm/s, vorzugsweise zwischen 8,0 mm/s und 13,0 mm/s, bewegt wird.

2. Verfahren zur Durchführung eines Abscheidungsprozesses an der Außenseite (1) und/oder an der Innenseite (2) eines eine Längserstreckung (L) aufweisenden Körpers (3), bei dem mittels eines Magnetron-Sputterprozesses mindestens eine Abscheidung auf die Außen- und/oder Innenseite (1, 2) des Körpers (3) aufgebracht wird, wobei der Körper (3) mit einem der Anschlüsse (4) einer Stromversorgung (5) verbunden wird und wobei mindestens ein innerhalb des Körpers (3) angeordnetes Radialmagnetron (23) und/oder mindestens ein um den Körper (3) herum angeordnetes Kreismagnetron (25) mit dem anderen der Anschlüsse (7) der Stromversorgung (5) verbunden wird, wobei das Radialmagnetron (23) und/oder das Kreismagnetron (25) nahe der Außen- oder Innenseite (1, 2) des Körpers (3) angeordnet ist, um die Abscheidung am Körper (3) durchzuführen, wobei das mindestens eine Radialmagnetron (23) und/oder das mindestens eine Kreismagnetron (25) entlang mindestens eines Teils der Längserstreckung (L) des Körpers (3) relativ zum Körper (3) mit einer vorbestimmten Geschwindigkeit bewegt wird,
**dadurch gekennzeichnet,**
**dass** das mindestens eine Radialmagnetron (23) und/oder das mindestens eine Kreismagnetron (25) mit einer Geschwindigkeit relativ zur Längserstreckung (L) des Körpers (3) zwischen 4,0 mm/s und 45,0 mm/s, vorzugsweise zwischen 8,0 mm/s und 13,0 mm/s, bewegt wird.

3. Verfahren nach Anspruch 1, **dadurch gekennzeichnet, dass** ein Druck zwischen 6,5 Pa und 70,0 Pa, vorzugsweise zwischen 25,0 Pa und 40,0 Pa, zwischen dem mindestens einen Filament (6) und dem Körper (3) aufrechterhalten wird.

4. Verfahren nach Anspruch 2, **dadurch gekennzeichnet, dass** zwischen dem mindestens einen Radialmagnetron (23) und/oder dem mindestens einen Kreismagnetron (25) und dem Körper (3) ein Druck zwischen 0,25 Pa und 1,5 Pa aufrechterhalten wird.

5. Verfahren nach Anspruch 1 oder 3, **dadurch gekennzeichnet, dass** ein Prozessgas, vorzugsweise CH₄ und/oder SiH₄, durch ein Versorgungselement (8) zu dem mindestens einen Filament (6) geführt wird, wobei das Versorgungselement (8) zusammen mit dem mindestens einen Filament (6) entlang der Längserstreckung (L) des Körpers (3) geführt wird.

6. Verfahren nach Anspruch 5, **dadurch gekennzeichnet, dass** zwei unterschiedliche Prozessgase, vorzugsweise CH₄ und SiH₄, durch ein Versorgungselement (8', 8") zu einem ersten und einem zweiten Filament (6', 6") geführt werden, wobei die Versorgungselemente (8', 8") zusammen mit dem ersten und zweiten Filament (6', 6") entlang der Längserstreckung (L) des Körpers (3) geführt werden.

7. Verfahren nach Anspruch 6, **dadurch gekennzeichnet, dass** zwischen dem ersten und zweiten Filament (6', 6") ein Trennelement (9) angeordnet ist, das einen Gasaustausch zwischen den Bereichen des ersten und zweiten Filaments (6', 6") verhindert.

8. Verfahren nach Anspruch 7, **dadurch gekennzeichnet, dass** ein radialer Abstand (b) zwischen dem Trennelement (9) und dem Körper (3) zwischen 0,5 mm und 0,8 mm eingehalten wird.

9. Verfahren nach Anspruch 2 oder 4, **dadurch gekennzeichnet, dass** ein Prozessgas, vorzugsweise Ar-Gas, durch ein Versorgungselement (8"') zu dem mindestens einen Radialmagnetron (23) und/oder zu dem mindestens einen Kreismagnetron (25) geführt wird, wobei das Versorgungselement (8"') zusammen mit dem mindestens einen Radialmagnetron (23) und/oder dem mindestens einen Kreismagnetron (25) entlang der Längserstreckung (L) des Körpers (3) geführt wird.

10. Verfahren nach einem der Ansprüche 1, 3, 5 bis 8, **dadurch gekennzeichnet, dass** mindestens ein erstes Filament (6') und mindestens ein zweites Filament (6") entlang mindestens eines Teils der Längserstreckung (L) des Körpers (3) bewegt werden, wobei das erste und das zweite Filament (6', 6") mit einem axialen Abstand (a) in Richtung der Längserstreckung (L) des Körpers (3) angeordnet werden.

11. Verfahren nach Anspruch 1 und 2, **dadurch gekennzeichnet, dass** mindestens ein Filament (6) und mindestens ein Radial- oder Kreismagnetron (23, 25) entlang mindestens eines Teils der Längserstreckung (L) des Körpers (3) bewegt werden, wobei das mindestens eine Filament (6) und das mindestens eine Radial- oder Kreismagnetron (23, 25) mit einem axialen Abstand (a) in Richtung der Längserstreckung (L) des Körpers (3) angeordnet werden.

12. Verfahren nach Anspruch 11, **dadurch gekennzeichnet, dass** zwei unterschiedliche Prozessgase, vorzugsweise CH₄ und Ar, durch jeweilige Versorgungselemente (8', 8", 8"') zu dem mindestens einen Filament (6) und dem mindestens einen Radial- oder Kreismagnetron (23, 25) geführt werden, wobei die Versorgungselemente (8', 8", 8"') zusammen mit dem mindestens einen Filament (6) und dem mindestens einen Radial- oder Kreismagnetron (23, 25) entlang der Längserstreckung (L) des Körpers (3) geführt werden.

13. Verfahren nach einem der Ansprüche 1 bis 12, **dadurch gekennzeichnet, dass** der Körper (3) eine rohrförmige Gestalt aufweist, wobei der Körper (3) vorzugsweise einen Außendurchmesser und eine Länge aufweist, wobei das Verhältnis von Länge zu Durchmesser mindestens 10 beträgt.

14. Vorrichtung zur Durchführung eines Abscheideprozesses an der Außenseite (1) und/oder an der Innenseite (2) eines eine Längserstreckung (L) aufweisenden Körpers (3) mittels eines Magnetron-Sputterprozesses, wobei die Vorrichtung eine Vakuumkammer (10) zur Aufnahme des Körpers (3) und eine Stromversorgung (5) mit zwei Anschlüssen (4, 7) aufweist, wobei ein Anschluss (4) mit dem Körper (3) und ein Anschluss (7) mit mindestens einem Radialmagnetron (23) und/oder einem Kreismagnetron (25) verbindbar ist,
**dadurch gekennzeichnet,**
**dass** Bewegungsmittel (11) zum Bewegen des mindestens einen Radialmagnetrons (23) und/oder Kreismagnetrons (25) relativ zum Körper (3) oder des Körpers (3) relativ zu dem mindestens einen Radialmagnetron (23) und/oder Kreismagnetron (25) entlang mindestens eines Teils der Längserstreckung (L) des Körpers (3) mit einer vorgegebenen Geschwindigkeit angeordnet sind.

15. Vorrichtung nach Anspruch 14, **dadurch gekennzeichnet, dass** mindestens ein Versorgungselement (8) zur Zuführung eines Prozessgases zu dem mindestens einen Radialmagnetron (23) und/oder Kreismagnetron (25) angeordnet ist.

## Revendications

1. Procédé destiné à réaliser une opération de dépôt sur le côté externe (1) et/ou sur le côté interne (2) d'un corps (3) ayant une extension longitudinale (L), dans lequel au moins un dépôt est appliqué sur le côté externe et/ou interne (1, 2) du corps (3) au moyen d'une opération de dépôt chimique en phase vapeur (CVD) ou d'une opération de dépôt chimique en phase vapeur assisté par plasma (PECVD) ou d'une opération de dépôt physique en phase vapeur (pulvérisation PVD), dans lequel le corps (3) est relié à l'une des bornes (4) d'une alimentation électrique (5) et dans lequel au moins un filament (6) est relié à l'autre des bornes (7) de l'alimentation électrique (5), l'au moins un filament (6) étant disposé près du côté externe ou interne (1, 2) du corps (3) pour réaliser le dépôt au niveau du corps (3), l'au moins un filament (6) étant déplacé le long d'au moins une partie de l'extension longitudinale (L) du corps (3) par rapport au corps (3) à une vitesse prédéterminée,
**caractérisé en ce que**
l'au moins un filament (6) est déplacé à une vitesse par rapport à l'extension longitudinale (L) du corps (3) comprise entre 4,0 mm/s et 45,0 mm/s, de préférence entre 8,0 mm/s et 13,0 mm/s.

2. Procédé destiné à réaliser une opération de dépôt sur le côté externe (1) et/ou sur le côté interne (2) d'un corps (3) ayant une extension longitudinale (L), dans lequel au moins un dépôt est appliqué sur le côté externe et/ou interne (1, 2) du corps (3) au moyen d'une opération de pulvérisation magnétron, dans lequel le corps (3) est relié à l'une des bornes (4) d'une alimentation électrique (5) et dans lequel au moins un magnétron radial (23), qui est disposé à l'intérieur du corps (3), et/ou au moins un magnétron circulaire (25), qui est disposé autour du corps (3), sont reliés à l'autre des bornes (7) de l'alimentation électrique (5), le magnétron radial (23) et/ou le magnétron circulaire (25) étant disposés près du côté externe ou interne (1, 2) du corps (3) pour réaliser le dépôt au niveau du corps (3), l'au moins un magnétron radial (23) et/ou l'au moins un magnétron circulaire (25) étant déplacés le long d'au moins une partie de l'extension longitudinale (L) du corps (3) par rapport au corps (3) à une vitesse prédéterminée,
**caractérisé en ce que**
l'au moins un magnétron radial (23) et/ou l'au moins un magnétron circulaire (25) sont déplacés à une vitesse par rapport à l'extension longitudinale (L) du corps (3) comprise entre 4,0 mm/s et 45,0 mm/s, de préférence entre 8,0 mm/s et 13,0 mm/s.

3. Procédé selon la revendication 1, **caractérisé en ce qu'**une pression comprise entre 6,5 Pa et 70,0 Pa, de préférence entre 25,0 Pa et 40,0 Pa, est maintenue entre l'au moins un filament (6) et le corps (3).

4. Procédé selon la revendication 2, **caractérisé en ce qu'**une pression comprise entre 0,25 Pa et 1,5 Pa est maintenue entre l'au moins un magnétron radial (23) et/ou l'au moins un magnétron circulaire (25) et le corps (3).

5. Procédé selon la revendication 1 ou 3, **caractérisé en ce qu'**un gaz de procédé, de préférence du CH₄ et/ou du SiH₄, est guidé à travers un élément d'amenée (8) jusqu'à l'au moins un filament (6), l'élément d'amenée (8) étant guidé conjointement avec l'au moins un filament (6) le long de l'extension longitudinale (L) du corps (3).

6. Procédé selon la revendication 5, **caractérisé en ce que** deux gaz de procédé différents, de préférence du CH₄ et du SiH₄, sont guidés à travers un élément d'amenée (8', 8") jusqu'à un premier et un deuxième filament (6', 6"), les éléments d'amenée (8', 8") étant guidés conjointement avec les premier et deuxième filaments (6', 6") le long de l'extension longitudinale (L) du corps (3) .

7. Procédé selon la revendication 6, **caractérisé en ce qu'**un élément de séparation (9) est disposé entre les premier et deuxième filaments (6', 6"), lequel empêche un échange de gaz entre les zones des premier et deuxième filaments (6', 6").

8. Procédé selon la revendication 7, **caractérisé en ce qu'**une distance radiale (b) entre l'élément de séparation (9) et le corps (3) est maintenue entre 0,5 mm et 0,8 mm.

9. Procédé selon la revendication 2 ou 4, **caractérisé en ce qu'**un gaz de procédé, de préférence de l'Ar gazeux, est guidé à travers un élément d'amenée (8"') jusqu'à l'au moins un magnétron radial (23) et/ou jusqu'à l'au moins un magnétron circulaire (25), l'élément d'amenée (8"') étant guidé conjointement avec l'au moins un magnétron radial (23) et/ou l'au moins un magnétron circulaire (25) le long de l'extension longitudinale (L) du corps (3).

10. Procédé selon une des revendications 1, 3, 5 à 8, **caractérisé en ce qu'**au moins un premier filament (6') et au moins un deuxième filament (6") sont déplacés le long d'au moins une partie de l'extension longitudinale (L) du corps (3), les premiers et les deuxièmes filaments (6', 6") étant disposés avec une distance axiale (a) dans la direction de l'extension longitudinale (L) du corps (3).

11. Procédé selon les revendications 1 et 2, **caractérisé en ce qu'**au moins un filament (6) et au moins un magnétron radial ou circulaire (23, 25) sont déplacés le long d'au moins une partie de l'extension longitudinale (L) du corps (3), l'au moins un filament (6) et l'au moins un magnétron radial ou circulaire (23, 25) étant disposés avec une distance axiale (a) dans la direction de l'extension longitudinale (L) du corps (3).

12. Procédé selon la revendication 11, **caractérisé en ce que** deux gaz de procédé différents, de préférence du CH₄ et de l'Ar, sont guidés à travers des éléments d'amenée respectifs (8', 8", 8"') jusqu'à l'au moins un filament (6) et l'au moins un magnétron radial ou circulaire (23, 25), les éléments d'amenée (8', 8", 8"') étant guidés conjointement avec l'au moins un filament (6) et l'au moins un magnétron radial ou circulaire (23, 25) le long de l'extension longitudinale (L) du corps (3) .

13. Procédé selon une des revendications 1 à 12, **caractérisé en ce que** le corps (3) a une forme tubulaire, le corps (3) ayant de préférence un diamètre extérieur et une longueur, le rapport entre la longueur et le diamètre valant au moins 10.

14. Dispositif destiné à réaliser une opération de dépôt sur le côté externe (1) et/ou sur le côté interne (2) d'un corps (3) ayant une extension longitudinale (L) au moyen d'une opération de pulvérisation magnétron, le dispositif comprenant une chambre à vide (10) destinée à recevoir le corps (3) et une alimentation électrique (5) avec deux bornes (4, 7), une borne (4) pouvant être reliée au corps (3) et une borne (7) étant reliée à au moins un magnétron radial (23) et/ou magnétron circulaire (25),
**caractérisé en ce que**
des moyens de déplacement (11) sont agencés pour déplacer l'au moins un magnétron radial (23) et/ou magnétron circulaire (25) par rapport au corps (3) ou le corps (3) par rapport à l'au moins un magnétron radial (23) et/ou magnétron circulaire (25) le long d'au moins une partie de l'extension longitudinale (L) du corps (3) à une vitesse prédéterminée.

15. Dispositif selon la revendication 14, **caractérisé en ce qu'**au moins un élément d'amenée (8) est agencé pour amener un gaz de procédé jusqu'à l'au moins un magnétron radial (23) et/ou magnétron circulaire (25).
